# EUROPEAN PATENT APPLICATION

(11) **EP 4 712 721 A1**
(43) Date of publication of application: **18.03.2026**
(21) Application number: 25197313.7
(22) Date of filing: 21.08.2025
(51) Int. Cl.: H10B 51/20, H10B 51/10, H10D 64/01, H10B 51/30, H10D 64/68, H10D 30/69

(54) **SEMICONDUCTOR DEVICE**

(30) Priority: 13.09.2024 KR 20240126167
(71) Applicant: Samsung Electronics Co., Ltd., Suwon-si, Gyeonggi-do 16677 (KR)
(72) Inventor: AHN, Sehyoung, 16677 Suwon-si (KR); JEON, Intak, 16677 Suwon-si (KR); CHOI, Jaehyoung, 16677 Suwon-si (KR)
(74) Representative: Marks & Clerk LLP

(57) **Abstract**

A semiconductor device may include: a substrate (101); conductive lines (140) spaced apart from each other in a first horizontal direction (X), the conductive lines extending in a second horizontal (Y) direction intersecting the first horizontal direction; at least one gate electrode (160) between the conductive lines in the first horizontal direction, the at least one gate electrode extending in a vertical direction (Z); channel layers (121) surrounding the at least one gate electrode, the channel layers spaced apart from each other in the vertical direction; a dielectric layer (151) between the channel layers and the at least one gate electrode; a metal layer (125) between the channel layers and the dielectric layer; a gate insulating layer (123) between the channel layers and the metal layer; and at least one interfacial layer (152) surrounding the at least one gate electrode, the at least one interfacial layer being between the channel layers and the at least one gate electrode.

## Description

### BACKGROUND

The present disclosure relates to a semiconductor device, and more particularly, to a semiconductor device including a ferroelectric field-effect transistor.

As electronic products are becoming more compact, multi-functional, and high-performance, high-capacity semiconductor memory devices are required. To this end, increased integration of memory devices is required. The integration of two-dimensional semiconductor memory devices is mainly determined by the area occupied by a unit memory cell. Thus, the integration of two-dimensional semiconductor memory devices is increasing but is still limited. Accordingly, a semiconductor device including three-dimensional semiconductor memory devices to increase the memory capacity by stacking a plurality of memory cells in a vertical direction on a substrate is proposed.

### SUMMARY

Provided is a semiconductor device in which an interfacial layer including molybdenum oxide (MoOx), niobium oxide (NbOx), titanium oxide (TiOx), tantalum oxide (TaOx), or a combination thereof is provided between a gate electrode and a dielectric layer.

According to an aspect of the disclosure, a semiconductor device may include: a substrate; conductive lines spaced apart from each other in a first horizontal direction parallel to a top surface of the substrate, the conductive lines extending in a second horizontal direction intersecting the first horizontal direction; at least one gate electrode between the conductive lines in the first horizontal direction, the at least one gate electrode extending in a vertical direction perpendicular to the substrate; channel layers surrounding the at least one gate electrode, the channel layers spaced apart from each other in the vertical direction; a dielectric layer between the channel layers and the at least one gate electrode; a metal layer between the channel layers and the dielectric layer; a gate insulating layer between the channel layers and the metal layer; and at least one interfacial layer surrounding the at least one gate electrode, the at least one interfacial layer being between the channel layers and the at least one gate electrode.

According to an aspect of the disclosure, a semiconductor device may include: a substrate; a gate electrode extending in a vertical direction on the substrate; channel layers surrounding the gate electrode , the channel layers spaced apart from each other in the vertical direction; a dielectric layer between the channel layers and the gate electrode; a metal layer between the channel layers and the dielectric layer; a gate insulating layer between the channel layers and the metal layer; and at least one interfacial layer surrounding the gate electrode, the at least one interfacial layer being between the channel layers and the gate electrode, wherein the at least one interfacial layer includes at least one from among molybdenum oxide (MoOx), niobium oxide (NbOx), titanium oxide (TiOx), and tantalum oxide (TaOx).

According to an aspect of the disclosure, a semiconductor device may include: a substrate; conductive lines spaced apart from each other in a first horizontal direction parallel to a top surface of the substrate and in a vertical direction perpendicular to the top surface of the substrate, the conductive lines extending in a second horizontal direction intersecting the first horizontal direction; a gate electrode between the conductive lines in the first horizontal direction, the gate electrode extending in the vertical direction; channel layers surrounding the gate electrode, the channel layers spaced apart from each other in the vertical direction; a dielectric layer between the channel layers and the gate electrode; a metal layer between the channel layers and the dielectric layer; a gate insulating layer between the channel layers and the metal layer; and a first interfacial layer between the gate electrode and the dielectric layer, the first interfacial layer extending in the vertical direction, and including at least one from among molybdenum oxide (MoOx), niobium oxide (NbOx), titanium oxide (TiOx), and tantalum oxide (TaOx).

At least some of the above and other features of the invention are set out in the claims.

Aspects of the disclosure are not limited to the aspects mentioned above, and other aspects of the disclosure not mentioned may be clearly understood by those skilled in the art from the following description.

### BRIEF DESCRIPTION OF THE DRAWINGS

The above and other aspects, features, and advantages of certain embodiments of the present disclosure will be more apparent from the following description taken in conjunction with the accompanying drawings, in which:
FIG. 1 is a schematic perspective view of a semiconductor device according to some embodiments;
FIG. 2a is a plan view of a semiconductor device according to some embodiments;
FIG. 2b is a cross-sectional view taken along a line A-A' in FIG. 1;
FIG. 3 is a plan view taken along a line B-B' in FIG. 2b;
FIGS. 4a to 4c are plan views taken along a line corresponding to the line B-B' in FIG. 2Bb to show partial configurations of semiconductor devices, according to some embodiments;
FIGS. 5a to 11b are diagrams illustrating a method of manufacturing a semiconductor device, according to some embodiments, wherein FIGS. 5a, 6a, 7a, 8a, 9a, 10a, and 11a are plan views illustrating a method of manufacturing a semiconductor device, and FIGS. 5b, 6b, 7b, 8b, 9b, 10b, and 11b are cross-sectional views taken along a line corresponding to the line A-A' in FIG. 1 to illustrate a method of manufacturing a semiconductor device; and
FIG. 12 is a graph showing a correlation between a leakage current of a field-effect transistor and a thickness of an interfacial layer.

### DETAILED DESCRIPTION

Hereinafter, non-limiting example embodiments are described in detail with reference to the accompanying drawings. The same reference numerals are used for the same components in the drawings, and redundant description thereof may be omitted.

It will be understood that when an element or layer is referred to as being "on," "connected to," or "coupled to" another element or layer, it can be directly on, connected to, or coupled to the other element or layer or intervening elements or layers may be present. In contrast, when an element or layer is referred to as being "directly on," "directly connected to," or "directly coupled to" another element or layer, there are no intervening elements or layers present.

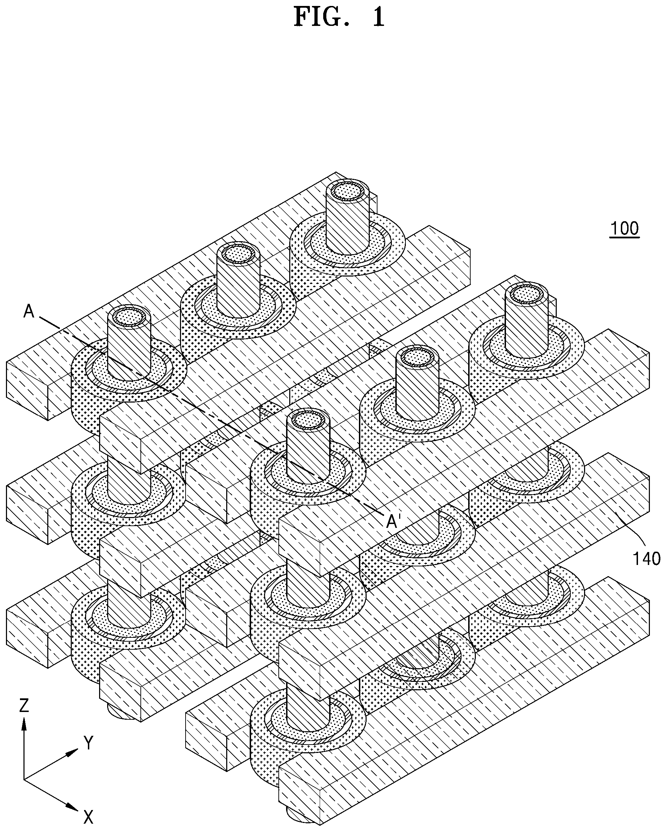

FIG. 1 is a schematic perspective view of a semiconductor device according to some embodiments.

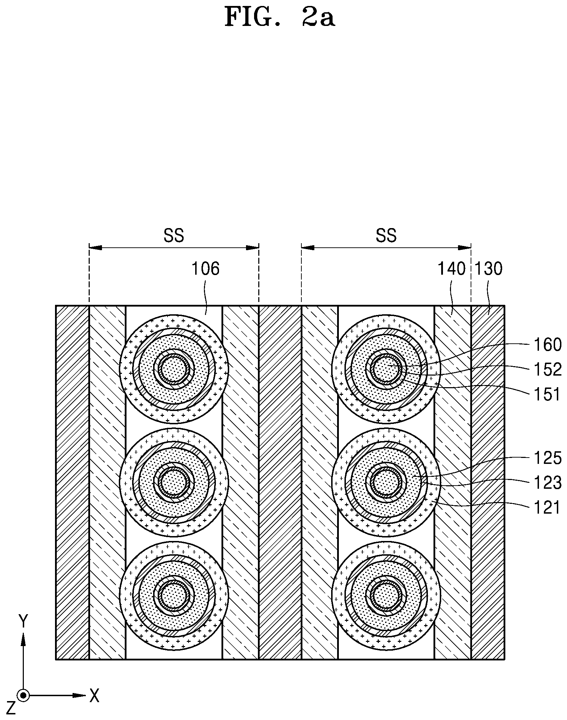

FIG. 2a is a plan view of a semiconductor device according to some embodiments.

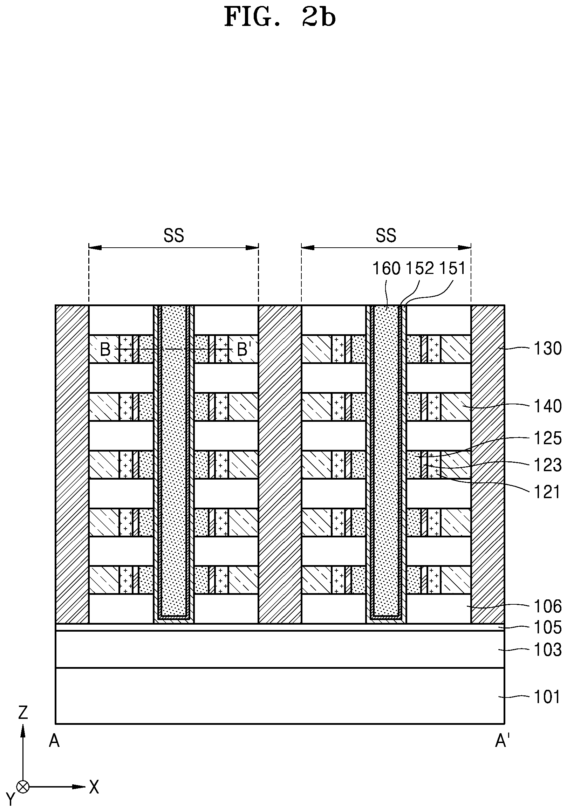

FIG. 2b is a cross-sectional view taken along a line A-A' in FIG. 1.

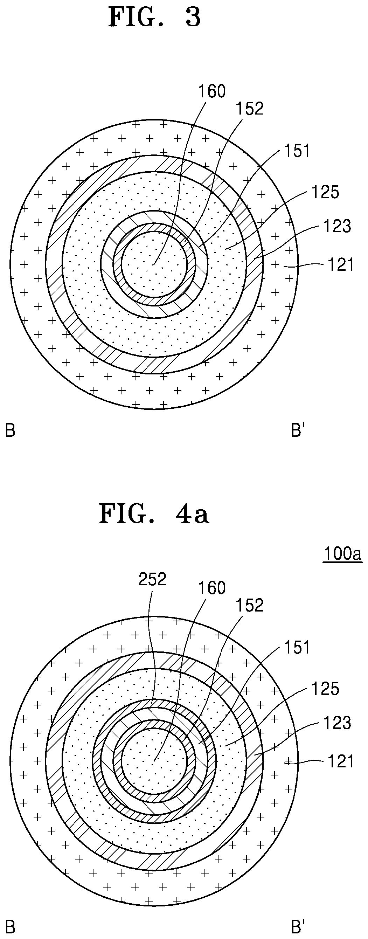

FIG. 3 is a plan view taken along a line B-B' in FIG. 2b.

Referring to FIGS. 1 to 3, a semiconductor device 100 according to an embodiment of the disclosure may include a substrate 101, an interlayer insulating film 103, an etch stop film 105, and a stacked structure SS. The interlayer insulating film 103 and the etch stop film 105 may be sequentially disposed on the substrate 101. The stacked structure SS may be disposed on the etch stop film 105.

In some embodiments, the substrate 101 may include a semiconductor material such as, for example, a group IV semiconductor, a group III-V compound semiconductor, or a group II-VI oxide semiconductor. For example, the group IV semiconductor may include silicon (Si), germanium (Ge), or silicon-germanium (Se-Ge). The substrate 101 may be provided as a bulk wafer or an epitaxial layer. In an embodiment, the substrate 101 may include a silicon-on-insulator (SOI) substrate or a germanium-on-insulator (GeOI) substrate.

In some embodiments, a peripheral circuit and a wiring layer connected to the peripheral circuit may be further formed on a partial region of the substrate 101. For example, the peripheral circuit may include, but is not limited to, a planar metal-oxide-semiconductor field-effect transistor (MOSFET) that constitutes a sub-word line driver, a sense amplifier, or the like. In addition, a lower insulating layer arranged to cover the peripheral circuit and the wiring layer may be further formed on the substrate 101.

In some embodiments, the interlayer insulating film 103 may include silicon oxide, silicon nitride, silicon oxynitride, and a combination thereof. The etch stop film 105 may include a metal oxide. For example, the etch stop film 105 may include silicon carbide (SiC), silicon nitride (SiN), nitrogen-doped silicon carbide (SiC:N), silicon oxycarbide (SiOC), aluminum nitride (AlN), aluminum oxynitride (AlON), aluminum oxide (AlO), aluminum oxycarbide (AlOC), or a combination thereof.

In some embodiments, the stacked structure SS may include a plurality of conductive lines 140. The plurality of conductive lines 140 may be spaced apart from each other in a vertical direction Z perpendicular to the substrate 101. In addition, the plurality of conductive lines 140 may be spaced apart from each other in a first horizontal direction X and may each extend in a second horizontal direction Y. The first horizontal direction X and the second horizontal direction Y may be parallel to the substrate 101 and may intersect with each other (e.g., may be perpendicular to each other). Adjacent ones of the conductive lines 140 may be spaced apart from each other in the first horizontal direction X with a gate electrode 160 therebetween. The term "horizontal" may refer to a direction parallel to the substrate 101 (e.g., parallel to an upper surface of the substrate 101 upon which the stacked structure SS is disposed). The term "vertical" may refer to a direction perpendicular to the substrate 101 (e.g., perpendicular to an upper surface of the substrate 101 upon which the stacked structure SS is disposed). It will be appreciated that these terms are defined relative to the structure of the semiconductor device, and therefore need not imply any particular orientation of the semiconductor device, in use.

In some embodiments, the plurality of conductive lines 140 may include a conductive material and may include, for example, doped polysilicon, a metal, a conductive metal nitride, a conductive metal silicide, a conductive metal oxide, or a combination thereof. The plurality of conductive lines 140 may include, but are not limited to, doped polysilicon, aluminum (Al), copper (Cu), titanium (Ti), tantalum (Ta), ruthenium (Ru), tungsten (W), molybdenum (Mo), platinum (Pt), nickel (Ni), cobalt (Co), titanium nitride (TiN), tantalum nitride (TaN), tungsten nitride (WN), niobium nitride (NbN), titanium aluminide (TiAl), titanium aluminum nitride (TiAlN), titanium silicide (TiSi), titanium silicon nitride (TiSiN), tantalum silicide (TaSi), tantalum silicon nitride (TaSiN), ruthenium titanium nitride (RuTiN), nickel silicide (NiSi), cobalt silicide (CoSi), iridium oxide (IrOx), ruthenium oxide (RuOx), or a combination thereof. The plurality of conductive lines 140 may include a two-dimensional semiconductor material. For example, the two-dimensional semiconductor material of the plurality of conductive lines 140 may include graphene, carbon nanotubes, or a combination thereof.

In some embodiments, a plurality of gate electrodes 160 may each extend lengthwise in the vertical direction Z on the substrate 101. The plurality of gate electrodes 160 may be spaced apart from each other in the first horizontal direction X and the second horizontal direction Y on the substrate 101. The plurality of gate electrodes 160 may be arranged in the second horizontal direction Y between the plurality of conductive lines 140. The plurality of gate electrodes 160 may be arranged between the plurality of conductive lines 140 in the first horizontal direction X. For instance, a column of gate electrodes 160 may be arranged in the second horizontal direction Y, and may be arranged between an adjacent pair of conductive lines 140.

In some embodiments, the stacked structure SS may further include a plurality of groups of channel layers 121 respectively surrounding side surfaces of the plurality of gate electrodes 160. The groups of the plurality of channel layers 121 may surround the plurality of gate electrodes 160, respectively. The plurality of channel layers 121 of a same group may each surround a same one gate electrode 160, and may be spaced apart from each other in the vertical direction Z and may overlap with each other in the vertical direction Z. The plurality of channel layers 121 may each have a ring shape to surround the gate electrode 160 in a plan view. The plurality of channel layers 121 may be arranged between adjacent ones of the conductive lines 140 in the first horizontal direction X. Each of the conductive lines 140 may be connected to one channel layer 121. In a plan view, the conductive lines 140 and the channel layers 121 respectively corresponding thereto may overlap with each other in the first horizontal direction X.

In some embodiments, the plurality of channel layers 121 may each include a source/drain region. The source/drain region may include a semiconductor material doped with, for example, impurities.

In some embodiments, the plurality of channel layers 121 may each include Si (e.g., polycrystalline Si, doped Si, or single crystal Si), Ge, Si-Ge, or an oxide semiconductor. In other embodiments, the plurality of channel layers 121 may each include an amorphous metal oxide, a polycrystalline metal oxide, or a combination thereof. For example, the plurality of channel layers 121 may include at least one from among an indium-gallium (In-Ga)-based oxide (IGO), an indium-zinc (In-Zn)-based oxide (IZO), or an In-Ga-Zn-based oxide (IGZO). For example, the channel layers 121 may include IGZO, tin (Sn)-IGZO, tungsten-doped indium oxide (IWO), copper disulfide (CuS₂), copper diselenide (CuSe₂), tungsten diselenide (WSe₂), indium gallium silicon oxide (InGaSiO), indium tin zinc oxide (InSnZnO), IZO, zinc oxide (ZnO), zinc titanium oxide (ZTO), yttrium-doped zinc oxide (YZO), zinc tin oxide (ZnSnO), tin oxynitride (ZnON), zirconium zinc tin oxide (ZrZnSnO), tin oxide (SnO), hafnium indium zinc oxide (HfInZnO), gallium zinc tin oxide (GaZnSnO), aluminum zinc tin oxide (AlZnSnO), ytterbium gallium zinc oxide (YbGaZnO), indium gallium oxide (InGaO), or a combination thereof. In addition, the channel layers 121 may include a two-dimensional semiconductor material. For example, the two-dimensional semiconductor material may include MoS₂, MoSe₂, WS₂, graphene, carbon nanotubes, or a combination thereof.

In some embodiments, the stacked structure SS may further include a first interfacial layer 152, a dielectric layer 151, a metal layer 125, and a gate insulating layer 123, each arranged between the gate electrode 160 and the channel layer 121. For example, the dielectric layer 151 may be arranged between each of the plurality of channel layers 121 and the corresponding one of the gate electrodes 160. The metal layer 125 may be arranged between each of the plurality of channel layers 121 and the dielectric layer 151. The gate insulating layer 123 may be arranged between each of the plurality of channel layers 121 and the metal layer 125. The first interfacial layer 152 may be arranged between the gate electrode 160 and the dielectric layer 151.

In some embodiments, a plurality of first interfacial layers 152, a plurality of dielectric layers 151, a plurality of metal layers 125, and a plurality of gate insulating layers 123 may be provided, and a respective one of each of the first interfacial layers 152 and the dielectric layers 151, and a respective one or more of the metal layers 125 and the gate insulating layers 123, may be provided to correspond to the plurality of gate electrodes 160.

In some embodiments, the first interfacial layer 152 may surround the side surface of the corresponding one of the gate electrodes 160. The dielectric layer 151 may surround the side surface of the corresponding one of the gate electrodes 160 and may be spaced apart from the side surface of the corresponding one of the gate electrodes 160 with the first interfacial layer 152 therebetween. The metal layer 125 may surround the side surface of the corresponding one of the gate electrodes 160 and may be spaced apart from the side surface of the corresponding one of the gate electrodes 160 with the first interfacial layer 152 and the dielectric layer 151 therebetween. The gate insulating layer 123 may surround the side surface of the corresponding one of the gate electrodes 160 and may be spaced apart from the side surface of the corresponding one of the gate electrodes 160 with the first interfacial layer 152, the dielectric layer 151, and the metal layer 125 therebetween.

In some embodiments, the first interfacial layer 152 may surround the side surface and the bottom surface of the gate electrode 160. The dielectric layer 151 may surround the side surface and the bottom surface of the gate electrode 160 with the first interfacial layer 152 therebetween. The bottom surface of the dielectric layer 151 may be in direct contact with the top surface of the etch stop film 105.

In some embodiments, the dielectric layer 151 may include hafnium oxide (HfO₂) having ferroelectric properties. The dielectric layer 151 may further include a dopant, wherein the dopant may include at least one from among zirconium (Zr), Si, Al, yttrium (Y), gadolinium (Gd), lanthanum (La), scandium (Sc), and strontium (Sr). The dielectric layer 151 may include, for example, HfO₂, HfZnO, HfSiO, HfSiON, HfTaO, HfTiO, HfZrO, or a combination thereof. For example, the dielectric layer 151 may include HfO₂ including a tetragonal phase, an orthorhombic phase, or a combination thereof.

In some embodiments, the metal layer 125 may surround the gate electrode 160 and surround at least a portion of the side surface of the dielectric layer 151. One gate electrode 160 may be surrounded by a plurality of metal layers 125. The plurality of metal layers 125 surrounding one gate electrode 160 may be spaced apart from each other in the vertical direction Z. The metal layers 125 may include at least one from among, for example, a doped semiconductor material, a conductive metal nitride, a metal, a metal oxide, and a metal-semiconductor compound.

In some embodiments, the gate insulating layer 123 may surround the gate electrode 160 to surround the outer surface of the metal layer 125. One gate electrode 160 may be surrounded by a plurality of gate insulating layers 123. The plurality of gate insulating layers 123 surrounding one gate electrode 160 may be spaced apart from each other in the vertical direction Z. The gate insulating layers 123 may include, for example, silicon oxide, silicon nitride, silicon oxynitride, or a combination thereof. In other embodiments, the gate insulating layers 123 may each include a high-k material. The high-k material may have a dielectric constant of about 10 to about 25. The high-k material may include, but is not limited to, for example, HfO₂, AlO, zirconium oxide (ZrO₂), or a combination thereof.

In some embodiments, the first interfacial layer 152 may include molybdenum oxide (MoOx), niobium oxide (NbOx), titanium oxide (TiOx), tantalum oxide (TaOx), or a combination thereof.

In some embodiments, the gate electrode 160 may include doped polysilicon, a metal, a conductive metal nitride, a conductive metal silicide, a conductive metal oxide, or a combination thereof. For example, the gate electrode 160 may include Mo, Nb, Ti, Ta, or a combination thereof.

In some embodiments, the gate electrode 160, the channel layer 121 surrounding the side surface of the gate electrode 160, and the first interfacial layer 152, the dielectric layer 151, the metal layer 125, and the gate insulating layer 123, each between the channel layer 121 and the corresponding one of the gate electrodes 160 may constitute a ferroelectric field-effect transistor (FeFET). Accordingly, a plurality of ferroelectric field-effect transistors may be easily stacked in the vertical direction (e.g., vertical direction Z), thereby facilitating the high integration of semiconductor devices. The plurality of ferroelectric field-effect transistors may form ferroelectric random access memory (FeRAM) cells. Accordingly, the semiconductor device 100 may be a FeRAM device.

In a semiconductor device, according to a comparative example, the reliability of the semiconductor device decreases due to the electric field concentration at the boundary between the gate electrode and the dielectric layer, while the intensity of the electric field applied to the gate insulating layer decreases. Since the electric field is proportional to the curvature, the intensity of the electric field applied to the boundary between the gate electrode located inside and the dielectric layer may increase. Thus, the durability of the semiconductor device may decrease.

The semiconductor device 100 of an embodiment of the disclosure may improve the durability and reliability of the semiconductor device by arranging the first interfacial layer 152 between the gate electrode 160 and the dielectric layer 151. In particular, by arranging the first interfacial layer 152 including MoOx, NbOx, TiOx, TaOx, or a combination thereof, the dielectric constant K may be increased, thereby improving the capacitance of the gate electrode 160. In addition, by alleviating the electric field concentration at the boundary between the gate electrode 160 and the dielectric layer 151 and increasing the orthorhombic phase ratio of the dielectric layer 151, the polarization characteristics of the dielectric layer 151 may be improved without increasing the leakage current.

In another embodiment, the gate electrode 160 may include a first gate electrode and a second gate electrode. The outer surface of the first gate electrode may be in contact with the interfacial layer, and the inner surface thereof may be in contact with the second gate electrode. That is, the second gate electrode may penetrate the first gate electrode. The first gate electrode may include Mo, Nb, or a combination thereof and the second gate electrode may include Ti.

In some embodiments, each of the plurality of conductive lines 140 may be electrically connected to an adjacent one of the channel layers 121 spaced apart from each other in the second horizontal direction Y. The corresponding one of the gate electrodes 160, the channel layer 121 surrounding the side surface of the corresponding one of the gate electrodes 160, and the first interfacial layer 152, the dielectric layer 151, the metal layer 125, and the gate insulating layer 123, each arranged between the channel layer 121 and the corresponding one of the gate electrodes 160, may constitute a ferroelectric field-effect transistor. For example, some of the plurality of conductive lines 140 may function as bit lines and others of the conducting lines 140 may function as source lines.

In some embodiments, the stacked structure SS may further include first insulating patterns 106 spaced apart from each other in the vertical direction Z and arranged between the plurality of channel layers 121. The first insulating patterns 106 and the plurality of channel layers 121 may be alternately stacked in the vertical direction Z. The plurality of channel layers 121 may be electrically separated (or insulated) from each other by the first insulating patterns 106. Each of the first insulating patterns 106 may surround the side surface of a corresponding one of the gate electrodes 160.

In some embodiments, the first insulating patterns 106 may extend between adjacent ones of the gate insulating layers 123 in the vertical direction Z and between adjacent ones of the metal layers 125 in the vertical direction Z. That is, the gate insulating layer 123 and the metal layer 125 may be arranged between adjacent ones of the first insulating patterns 106, among the first insulating patterns 106, in the vertical direction Z. The dielectric layer 151 may extend between each of the first insulating patterns 106 and the corresponding one of the gate electrodes 160. The first insulating patterns 106 may contact the side surface of the dielectric layer 151. The first insulating patterns 106 may include, for example, silicon oxide.

In some embodiments, sidewall insulating patterns 130 may be disposed on the etch stop film 105 and on opposite side surfaces of the stacked structure SS. The sidewall insulating patterns 130 may be spaced apart from each other in the first horizontal direction X with the stacked structure SS therebetween. The sidewall insulating patterns 130 may extend in the vertical direction Z and the second horizontal direction Y. The sidewall insulating patterns 130 may extend in the vertical direction Z to cover the side surfaces of the plurality of conductive lines 140 and the first insulating patterns 106. The sidewall insulating patterns 130 may include, for example, silicon oxide, silicon nitride, silicon oxynitride, or a combination thereof.

FIGS. 4a to 4c are plan views taken along a line corresponding to line B-B' in FIG. 2b to show partial configurations of semiconductor devices according to some embodiments. The components of semiconductor devices 100a, 100b, and 100c described below with reference to FIG. 4a to FIG. 4c are similar to the components of the semiconductor device 100 described with reference to FIG. 1 to FIG. 3. Thus, hereinafter, differences therebetween are mainly described.

Referring to FIG. 4a, the stacked structure SS (see FIG. 1) of the semiconductor device 100a of an embodiment of the disclosure may further include a second interfacial layer 252. The second interfacial layer 252 may be arranged between the dielectric layer 151 and the metal layer 125. The second interfacial layer 252 may surround the side surface of the dielectric layer 151. The second interfacial layer 252 may surround the side surface of the corresponding one of the gate electrodes 160 and may be spaced apart from the side surface of the corresponding one of the gate electrodes 160 with the first interfacial layer 152 and the dielectric layer 151 therebetween.

In some embodiments, the second interfacial layer 252 may include MoOx, NbOx, TiOx, TaOx, or a combination thereof.

In some embodiments, a plurality of the second interfacial layer 252 may be provided such as to respectively correspond to the plurality of gate electrodes 160.

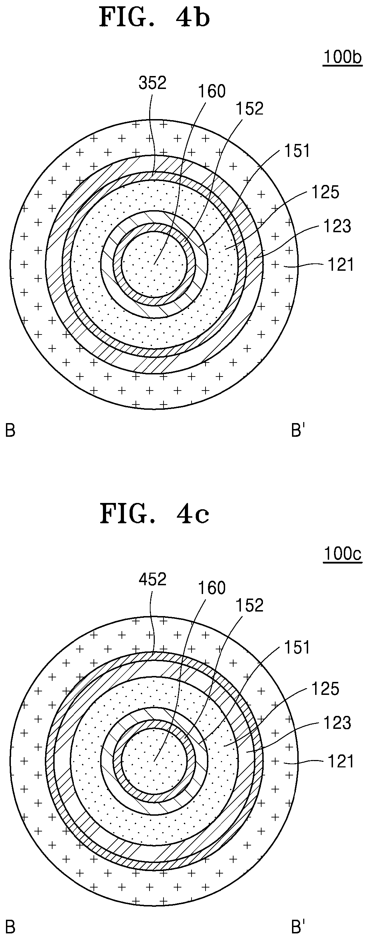

Referring to FIG. 4b, the stacked structure SS (see FIG. 1) of the semiconductor device 100b of an embodiment of the disclosure may further include a third interfacial layer 352. The third interfacial layer 352 may be arranged between the metal layer 125 and the gate insulating layer 123. The third interfacial layer 352 may surround the side surface of the metal layer 125. The third interfacial layer 352 may surround the side surface of the corresponding one of the gate electrodes 160 and may be spaced apart from the side surface of the corresponding one of the gate electrodes 160 with the first interfacial layer 152, the dielectric layer 151, and the metal layer 125 therebetween.

In some embodiments, the third interfacial layer 352 may include MoOx, NbOx, TiOx, TaOx, or a combination thereof.

In some embodiments, a plurality of the third interfacial layer 352 may be provided such as to respectively correspond to the plurality of gate electrodes 160.

Referring to FIG. 4c, the stacked structure SS (see FIG. 1) of the semiconductor device 100c of an embodiment of the disclosure may further include a fourth interfacial layer 452. The fourth interfacial layer 452 may be arranged between the gate insulating layer 123 and the channel layer 121. The fourth interfacial layer 452 may surround the side surface of the gate insulating layer 123. The fourth interfacial layer 452 may surround the side surface of the corresponding one of the gate electrodes 160 and may be spaced apart from the side surface of the corresponding one of the gate electrodes 160 with the first interfacial layer 152, the dielectric layer 151, the metal layer 125, and the gate insulating layer 123 therebetween.

In some embodiments, the fourth interfacial layer 452 may include MoOx, NbOx, TiOx, TaOx, or a combination thereof.

In some embodiments, a plurality of the fourth interfacial layer 452 may be provided such as to respectively correspond to the plurality of gate electrodes 160.

Referring to FIGS. 4a to 4c, the semiconductor devices 100a, 100b, and 100c are shown to include one interfacial layer (e.g., the second interfacial layer 252, the third interfacial layer 352, or the fourth interfacial layer 452), in addition to the first interfacial layer 152, but are not limited thereto. The semiconductor devices 100a, 100b, 100c of an embodiment of the disclosure may include one or more interfacial layers in addition to the first interfacial layer 152. For example, the semiconductor devices 100a, 100b, 100c may include the first interfacial layer 152, the second interfacial layer 252, and the third interfacial layer 352 together. Alternatively, the semiconductor devices 100a, 100b, 100c may include the first interfacial layer 152, the second interfacial layer 252, the third interfacial layer 352, and the fourth interfacial layer 452 together.

The semiconductor devices 100a, 100b, and 100c of an embodiment of the disclosure may further improve the durability and reliability of the semiconductor device by providing the second interfacial layer 252, the third interfacial layer 352, and the fourth interfacial layer 452 therein. In particular, by arranging the second interfacial layer 252, the third interfacial layer 352, and the fourth interfacial layer 452 including MoOx, NbOx, TiOx, TaOx, or a combination thereof, the electric field concentration at the boundary between the gate electrode 160 and the dielectric layer 151 may be alleviated and the orthorhombic phase ratio of the dielectric layer 151 may be increased, thereby improving the polarization characteristics of the dielectric layer 151 without increasing the leakage current.

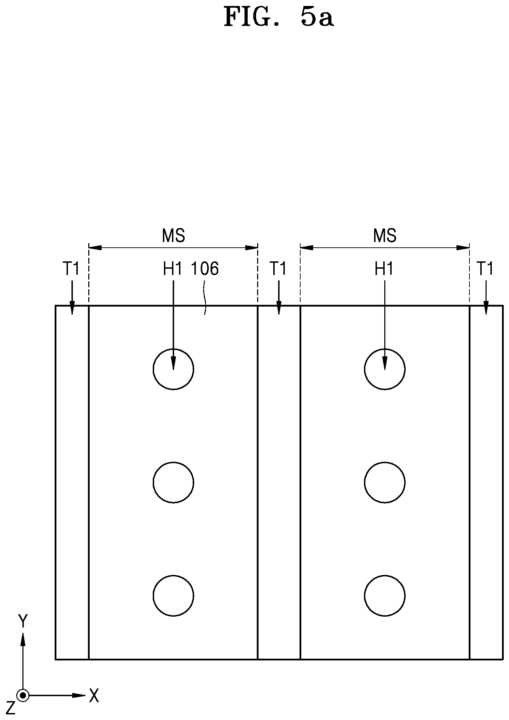

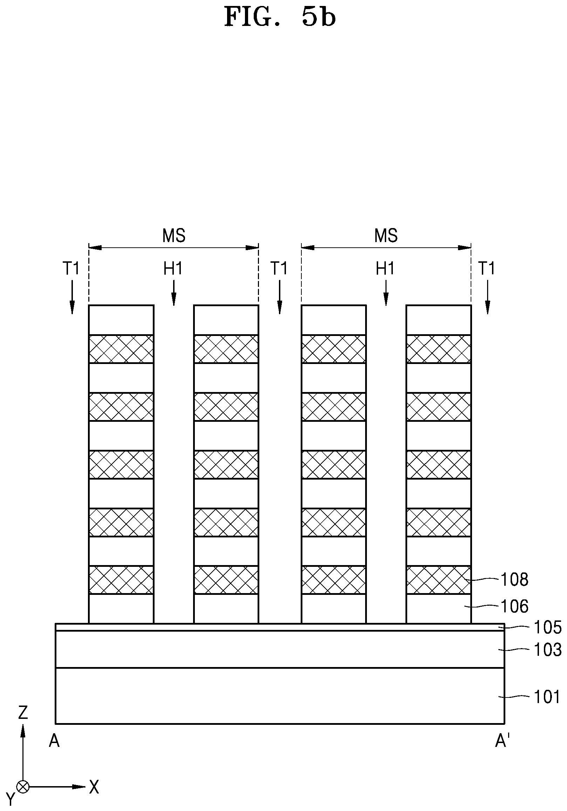

FIGS. 5a to 11b are diagrams illustrating a method of manufacturing a semiconductor device, according to some embodiments, wherein FIGS. 5a, 6a, 7a, 8a, 9a, 10a, and 11A are plan views illustrating a method of manufacturing a semiconductor device, and FIGS. 5b, 6b, 7b, 8b, 9b, 10b, and 11b are cross-sectional views taken along a line corresponding to line A-A' in FIG. 1 to illustrate a method of manufacturing a semiconductor device. In describing FIGS. 5a to 11b, descriptions that are substantially the same as those given above with reference to FIGS. 1 to 3 may be omitted.

Referring to FIGS. 5a and 5b, an interlayer insulating film 103 and an etch stop film 105 may be sequentially formed on a substrate 101. A first insulating film and a second insulating film may be alternatively stacked on the etch stop film 105. The first insulating film and the second insulating film may be alternately stacked in the vertical direction Z perpendicular to the top surface of the substrate 101. The first insulating film may include silicon oxide. The second insulating film may include a material having etching selectivity with respect to the first insulating film. For example, the second insulating film may include silicon nitride.

In some embodiments, a plurality of first trenches T1 may be formed in the first insulating film and the second insulating film. The first insulating film and the second insulating film may be anisotropically etched to form the first trenches T1. The first trenches T1 may pass through the first insulating film and the second insulating film in the vertical direction Z and may expose the top surface of the etch stop film 105. As the first trenches T1 are formed, the first insulating film and the second insulating film may form first insulating patterns 106 and second insulating patterns 108, respectively.

In some embodiments, the first trenches T1 may be spaced apart from each other in the first horizontal direction X parallel to the top surface of the substrate 101 and may extend in the second horizontal direction Y parallel to the top surface of the substrate 101. The second horizontal direction Y may intersect the first horizontal direction X.

In some embodiments, a mold structure MS may be defined by the first trenches T1. The mold structure MS may include the first insulating patterns 106 and the second insulating patterns 108 alternately stacked in the vertical direction Z. The first trenches T1 may be spaced apart from each other in the first horizontal direction X with the mold structure MS therebetween and may extend in the second horizontal direction Y. The mold structure MS may extend in the second horizontal direction Y between the first trenches T1.

In some embodiments, first holes H1 may be formed within the mold structure MS. Each of the first holes H1 may extend in the vertical direction Z to pass through the mold structure MS and expose the top surface of the etch stop film 105. The first holes H1 may be spaced apart from each other in the second horizontal direction Y between the first trenches T1.

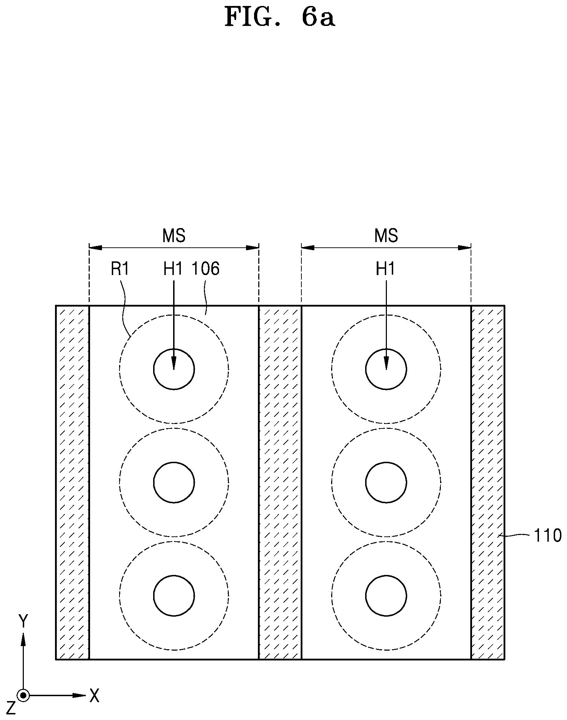

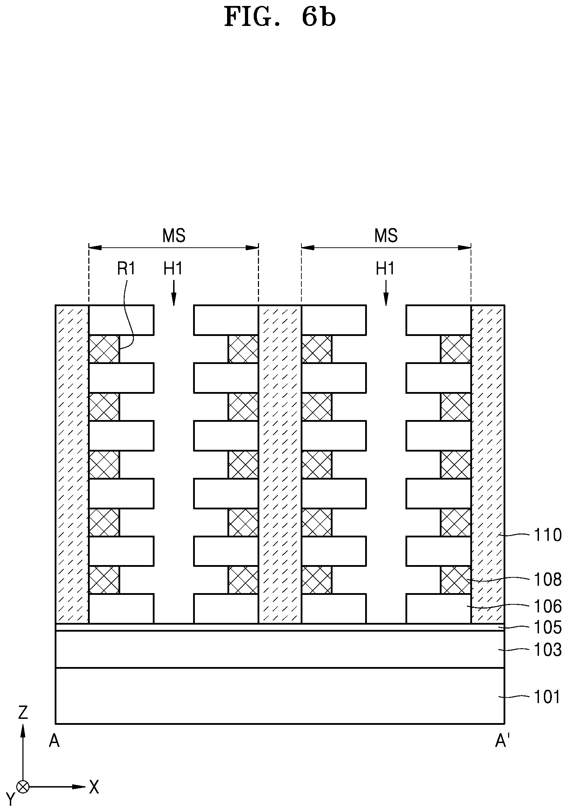

Referring to FIGS. 6a and 6b, first sacrificial patterns 110 may be formed in the first trenches T1, respectively. The first sacrificial patterns 110 may be formed to respectively fill the first trenches T1. The first sacrificial patterns 110 may be spaced apart from each other in the first horizontal direction X with the mold structure MS therebetween and may extend in the second horizontal direction Y. The first sacrificial patterns 110 may cover both side surfaces of the mold structure MS. The first sacrificial patterns 110 may include a material having etch selectivity to the second insulating patterns 108.

In some embodiments, the first hole H1 may expose side surfaces of the first insulating patterns 106 and the second insulating patterns 108 of the mold structure MS. The exposed side surfaces of the second insulating patterns 108 may be selectively recessed. Accordingly, first recessed regions R1 may be formed in the mold structure MS. An etching process with etching selectivity may be performed on the second insulating patterns 108 to remove part of the exposed side surfaces of the second insulating patterns 106 to form the first recessed regions R1. The first recessed regions R1 may be spaced apart from each other in the vertical direction Z and may each be positioned between the first insulating patterns 106. Each of the first recessed regions R1 may be formed to surround (e.g., in horizontal directions) the first hole H1 in a plan view.

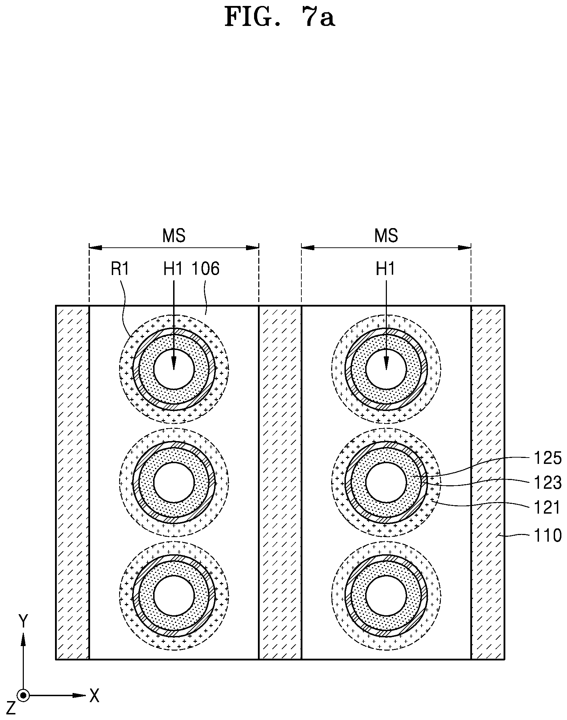

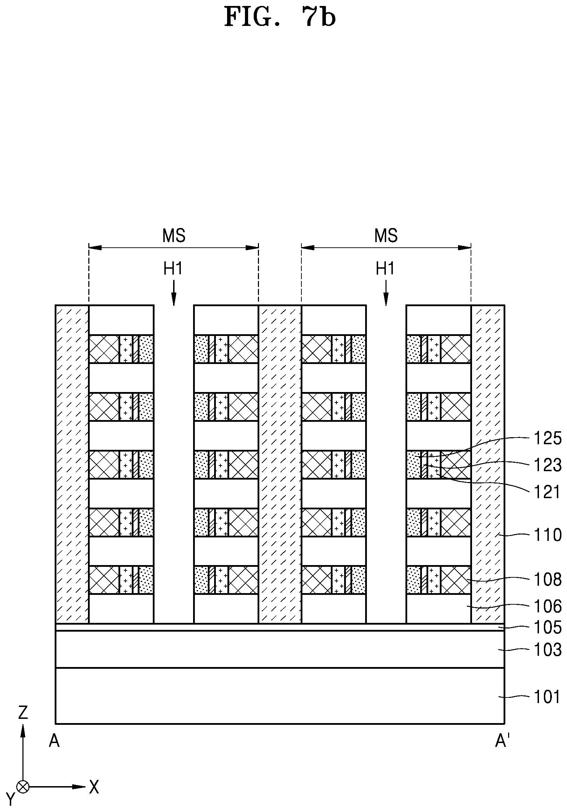

Referring to FIGS. 7a and 7b, a channel layer 121, a gate insulating layer 123, and a metal layer 125 may be sequentially formed in the first recessed region R1. The channel layer 121, the gate insulating layer 123, and the metal layer 125 may fill part of the first recessed region R1. For example, the channel layer 121 may be formed to cover the side surface of the second insulating pattern 108 and fill the first recessed region R1. The gate insulating layer 123 may be formed to cover the side surface of the channel layer 121 and fill the first recessed region R1. The metal layer 125 may be formed to cover the side surface of the gate insulating layer 123 and fill the first recessed region R1.

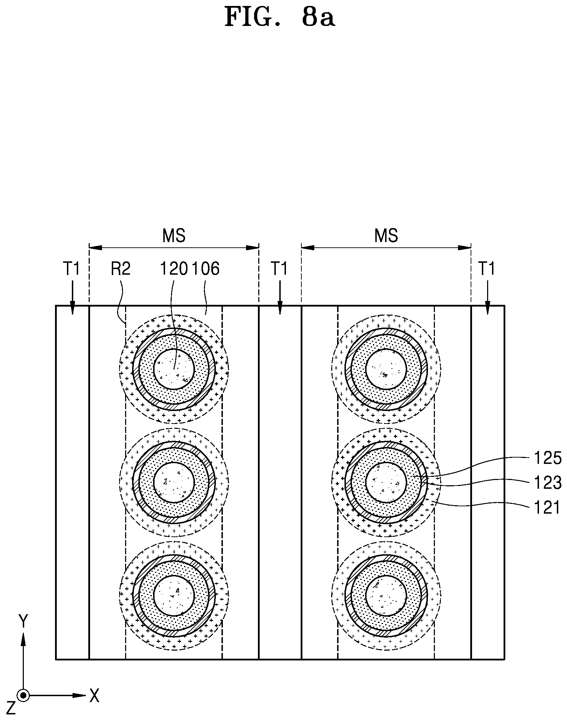

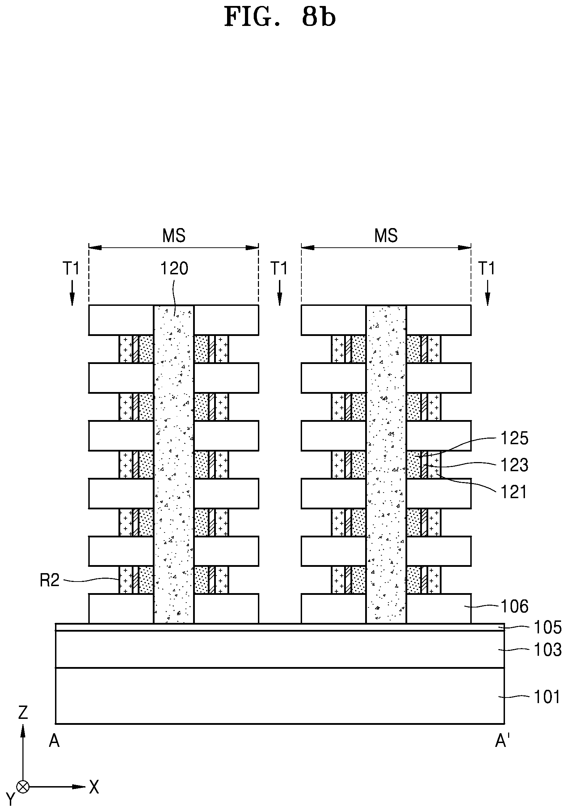

Referring to FIGS. 8a and 8b, second sacrificial patterns 120 may be formed in the first holes H1. The second sacrificial patterns 120 may be formed to fill the first holes H1, respectively. The second sacrificial patterns 120 may be spaced apart from each other in the second horizontal direction Y within the mold structure MS. The second sacrificial patterns 120 may include a material having etch selectivity with respect to the second insulating patterns 108.

The first sacrificial patterns 110 may then be removed from the first trenches T1. As the first sacrificial patterns 110 are removed, the first trenches T1 may expose side surfaces of the first insulating patterns 106 and the second insulating patterns 108 of the mold structure MS. The exposed side surfaces of the second insulating patterns 108 may be selectively recessed. Accordingly, second recessed regions R2 may be formed in the mold structure MS. An etching process with etching selectivity may be performed on the second insulating patterns 108 to remove part of the exposed side surfaces of the second insulating patterns 106, thereby forming the second recessed regions R2. The second recessed regions R2 may expose the side surfaces of the channel layers 121. The second recessed regions R2 may be spaced apart from each other in the vertical direction Z and may be each positioned between the first insulating patterns 106. Each of the second recessed regions R2 may have a line shape extending in the second horizontal direction Y.

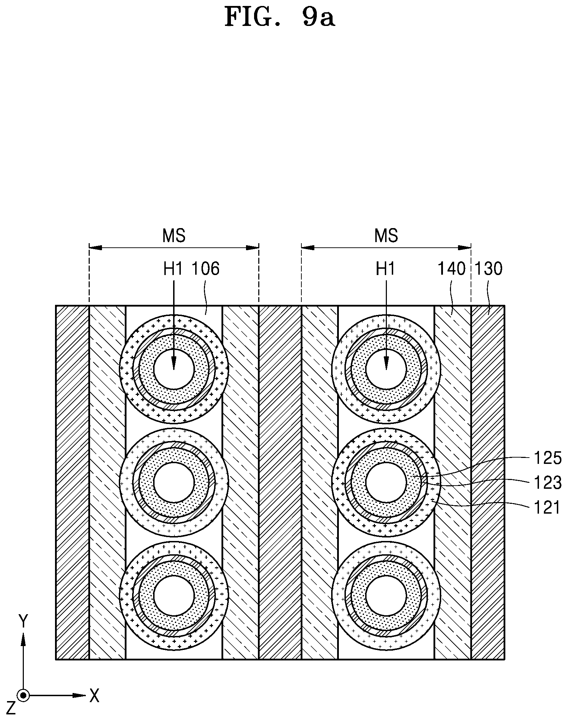

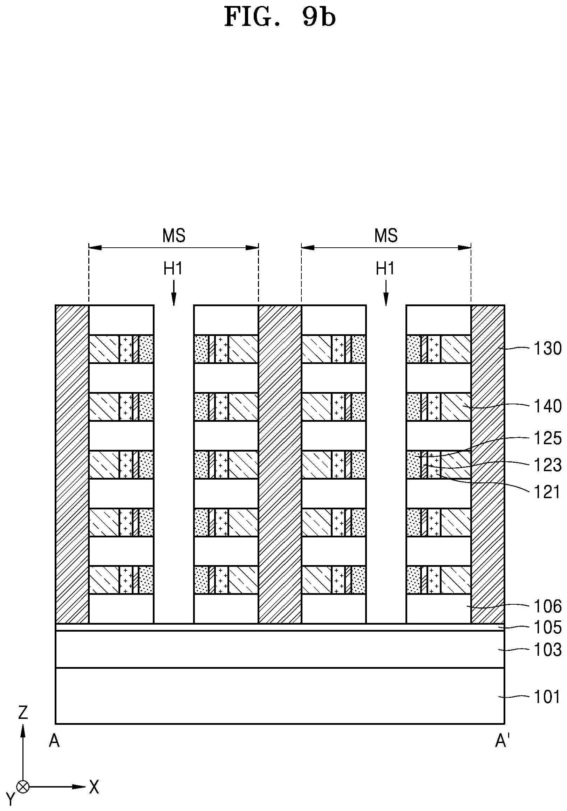

Referring to FIGS. 9a and 9b, a conductive line 140 may be formed in the second recessed region R2. A plurality of conductive lines 140 may each be formed in a corresponding one of the second recessed regions R2. The conductive lines 140 may fill the second recessed regions R2 and contact the side surfaces of the channel layers 121.

In some embodiments, the conductive lines 140 may be spaced apart from each other in the vertical direction Z. The first insulating patterns 106 may each be positioned between the conductive lines 140. The plurality of conductive lines 140 may be spaced apart from each other in the first horizontal direction X and may extend in the second horizontal direction Y.

Then, sidewall insulating patterns 130 may be respectively formed in the first trenches T1. The sidewall insulating patterns 130 may be formed to respectively fill the first trenches T1. The sidewall insulating patterns 130 may be spaced apart from each other in the first horizontal direction X with the mold structure MS therebetween. The sidewall insulating patterns 130 may extend in the vertical direction Z to cover the side surfaces of the conductive lines 140. The sidewall insulating patterns 130 may have a line shape extending in the second horizontal direction Y. The second sacrificial patterns 120 may then be removed from the first holes H1.

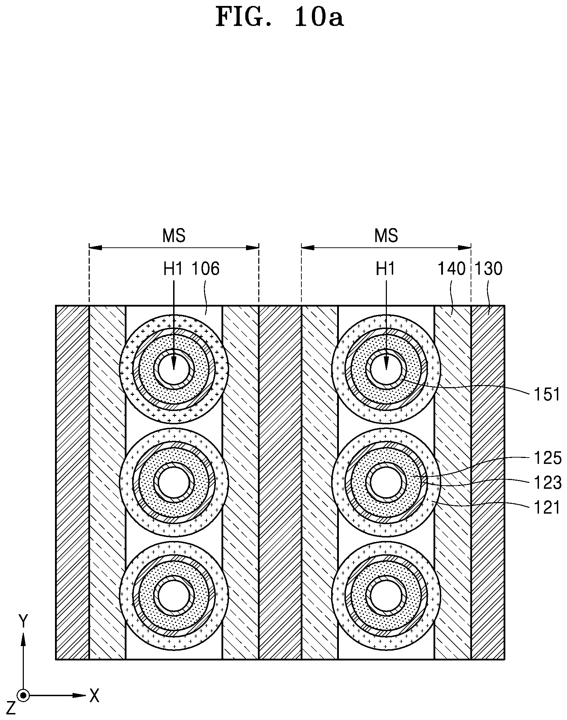

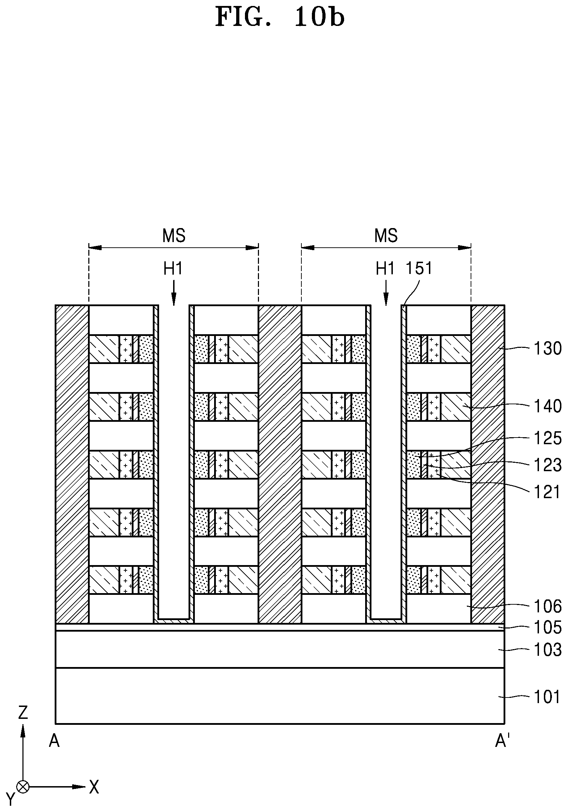

Referring to FIGS. 10a and 10b, a dielectric layer 151 may be formed in each of the first holes H1. The dielectric layer 151 may conformally cover the inner surface of the first hole H1. The dielectric layer 151 may cover the side surface of the metal layer 125, the side surfaces of the first insulating patterns 106, and the top surface of the etch stop film 105.

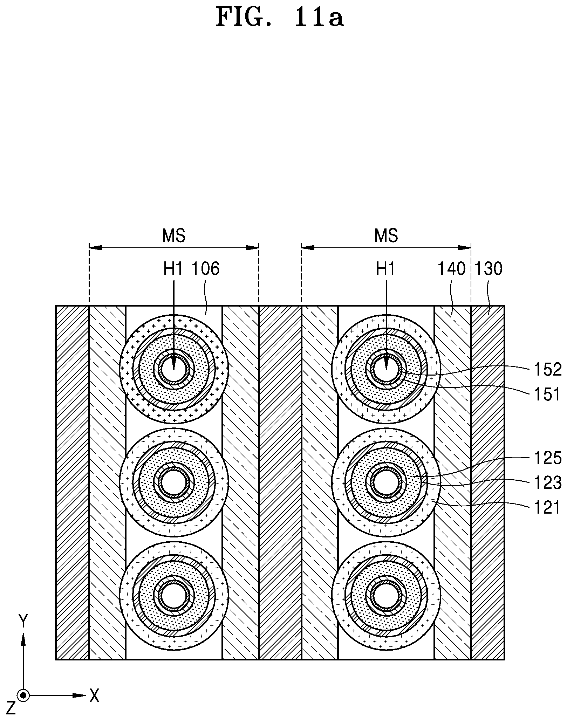

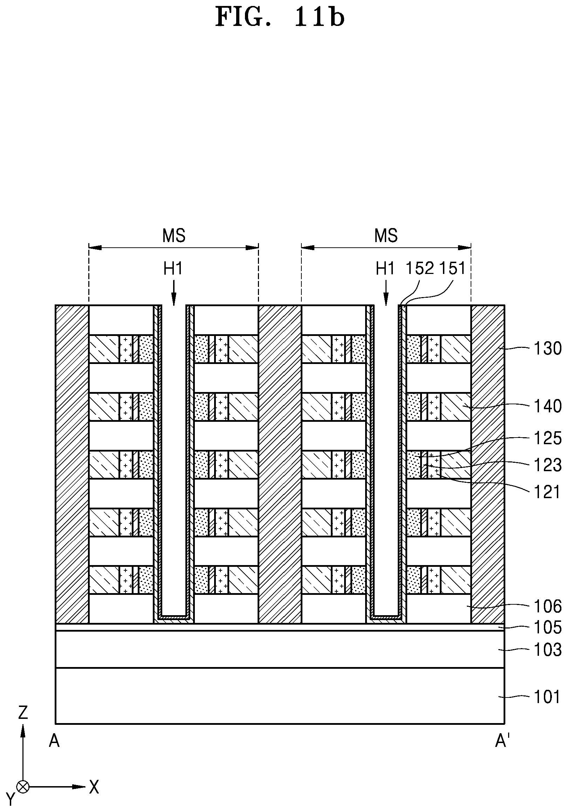

Referring to FIGS. 11a and 11b, a first interfacial layer 152 may be formed in each of the first holes H1. The first interfacial layer 152 may conformally cover the inner surface and the bottom surface of the dielectric layer 151 while filling the first hole H1. The process of forming the first interfacial layer 152 may include an atomic layer deposition (ALD) process but is not limited thereto. After forming the first interfacial layer 152, an additional heat treatment process may be performed. The heat treatment process may increase the formation of the ferroelectric phase in the dielectric layer 151.

Referring again to FIGS. 2a and 2b, the gate electrode 160 may be formed in the first hole H1. The gate electrode 160 may cover the first interfacial layer 152 while filling the first hole H1. The additional heat treatment process may be performed even after the gate electrode 160 is formed. As a result, the gate electrode 160, the first interfacial layer 152, the dielectric layer 151, the metal layer 125, the gate insulating layer 123, the channel layer 121, the conductive line 140, and the first insulating patterns 106 may constitute the stacked structure SS.

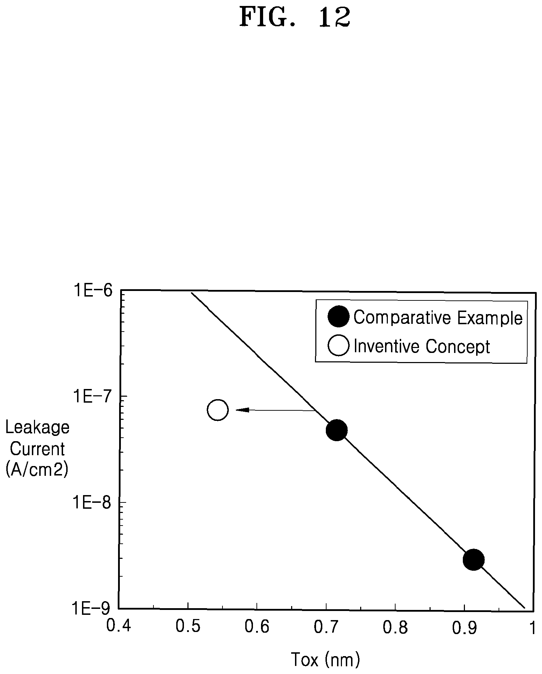

FIG. 12 is a graph showing the correlation between the leakage current of a field-effect transistor and the thickness of an interfacial layer.

Referring to FIG. 12, the semiconductor device 100 of an embodiment of the disclosure has a greater capacitance at the same leakage current than a capacitance the semiconductor device according to the comparative example. Thus, it may be seen that the equivalent oxide thickness (Tox) of the first interfacial layer 152 is reduced. In this case, the semiconductor device according to the comparative example includes a gate electrode including Ti and an interfacial layer including TiOx, while the semiconductor device 100 of an embodiment of the disclosure may include the gate electrode 160 including Mo and the first interfacial layer 152 including MoOx. That is, in the case of the field-effect transistor including the gate electrode 160 including Mo and the first interfacial layer 152 including MoOx, the dielectric constant K may be increased, thereby improving the capacitance of the gate electrode 160.

While non-limiting example embodiments of the disclosure have been described above with reference to the accompanying drawings, it will be understood that various changes in form and details may be made therein without departing from the scope of the disclosure.

## Claims

1. A semiconductor device comprising:
a substrate (101);
conductive lines (140) spaced apart from each other in a first horizontal direction parallel to a top surface of the substrate (101), the conductive lines (140) extending in a second horizontal direction intersecting the first horizontal direction;
at least one gate electrode (160) between the conductive lines (140) in the first horizontal direction, the at least one gate electrode (160) extending in a vertical direction perpendicular to the substrate (101);
channel layers (121) surrounding the at least one gate electrode (160) and spaced apart from each other in the vertical direction;
a dielectric layer (151) between the channel layers (121) and the at least one gate electrode (160);
a metal layer (125) between the channel layers (121) and the dielectric layer (151);
a gate insulating layer (123) between the channel layers (121) and the metal layer (125); and
at least one interfacial layer (152, 252, 352, 452) surrounding the at least one gate electrode (160), the at least one interfacial layer (152) being between the channel layers (121) and the at least one gate electrode (160).

2. The semiconductor device of claim 1, wherein the at least one interfacial layer (152, 252, 352, 452) comprises a first interfacial layer (152) between the at least one gate electrode (160) and the dielectric layer (151) and extending in the vertical direction.

3. The semiconductor device of claim 1 or claim 2, wherein the at least one interfacial layer (152, 252, 352, 452) comprises a second interfacial layer (252) between the dielectric layer (151) and the metal layer (125).

4. The semiconductor device of any preceding claim, wherein the interfacial layer (152, 252, 352, 452) comprises a third interfacial layer (352) arranged between the metal layer (125) and the gate insulating layer (123).

5. The semiconductor device of any preceding claim, wherein the interfacial layer (152, 252, 352, 452) comprises a fourth interfacial layer (452) arranged between the gate insulating layer (123) and the channel layer (121).

6. The semiconductor device of any preceding claim, wherein the at least one interfacial layer (152, 252, 352, 452) comprises at least one from among molybdenum oxide, niobium oxide, titanium oxide, and tantalum oxide.

7. The semiconductor device of any preceding claim, wherein the at least one gate electrode (160) comprises at least one from among molybdenum, niobium and titanium, and tantalum.

8. The semiconductor device of claim 7, wherein the at least one gate electrode (160) is a plurality of gate electrodes (160) that comprises:
a first gate electrode contacting the at least one interfacial layer; and
a second gate electrode passing through the first gate electrode.

9. The semiconductor device of claim 8, wherein the first gate electrode comprises molybdenum or niobium, and the second gate electrode comprises titanium.

10. The semiconductor device of any preceding claim, wherein the dielectric layer (151) comprises a ferroelectric material.

11. A semiconductor device comprising:
a substrate (101);
a gate electrode (160) extending in a vertical direction on the substrate (101);
channel layers (121) surrounding the gate electrode (160) and spaced apart from each other in the vertical direction;
a dielectric layer (151) between the channel layers (121) and the gate electrode (160);
a metal layer (125) between the channel layers (121) and the dielectric layer (151);
a gate insulating layer (123) between the channel layers (121) and the metal layer (125); and
at least one interfacial layer (152, 252, 352, 452) surrounding the gate electrode (160) and between the channel layers (121) and the gate electrode (160),
wherein the at least one interfacial layer (152, 252, 352, 452) comprises at least one from among molybdenum oxide, niobium oxide, titanium oxide, and tantalum oxide.

12. The semiconductor device of claim 11, wherein the at least one interfacial layer (152, 252, 352, 452) comprises a first interfacial layer (152) between the gate electrode (160) and the dielectric layer (151), the first interfacial layer (152) extending in the vertical direction.

13. The semiconductor device of claim 12, wherein the first interfacial layer (152) surrounds a side surface and a bottom surface of the gate electrode (160).

14. The semiconductor device of claim 12 or claim 13, wherein the at least one interfacial layer (152, 252, 352, 452) further comprises at least one second interfacial layer (252, 352, 452) that is:
between the dielectric layer (151) and the metal layer (125); or
between the metal layer (125) and the gate insulating layer (123); or
between the gate insulating layer (123) and at least one of the channel layers (121).

15. The semiconductor device of claim 14, wherein the at least one second interfacial layer (252, 352, 452) surrounds the gate electrode (160).
